# EUROPEAN PATENT SPECIFICATION

(11) **EP 0 474 194 B1**
(45) Date of publication and mention of the grant of the patent: **15.01.1997**
(21) Application number: 91114851.8
(22) Date of filing: 03.09.1991
(51) Int. Cl.: H05K 3/00, G03F 7/027, G03F 7/035, G03F 7/16

(54) **Method of masking electronic devices during processing and ultraviolet radiation curable maskant therefor**
Verfahren zur Maskierung von elektronischen Anordnungen während der Verarbeitung und durch Ultraviolettstrahlung härtbare Maskierungszusammensetzung dazu
Procédé pour le masquage de dispositifs électroniques pendant le traitement et composition masquante durcissable par radiation ultraviolette à cet effet

(30) Priority: 04.09.1990 US 577406
(43) Date of publication of application: 11.03.1992
(73) Proprietor: DOW CORNING CORPORATION, Midland Michigan 48686-0994 (US)
(72) Inventor: Juen, Donnie Ray, Sandord, Michigan (US)
(74) Representative: Spott, Gottfried, Dr.

(56) References cited:
- EP-A- 0 255 286
- EP-A- 0 384 616
- US-A- 4 380 613
- US-A- 4 686 171

## Description

This invention relates to ultraviolet curable maskant which are useful in the electronics industry.

In the electronics industry printed circuit boards are commonly conformally coated, cleaned and wave soldered. These processes can adversely affect the operation or interfere with the insertion of certain components and therefore there is a need to protect the area or component by masking the area with a temporary protective coating. Some of the components which need to be masked include connectors, stand offs, sockets, dip switches, trim pots and chip carriers. Although there are masking materials available commercially, these materials suffer from various disadvantages including inadequate solvent resistance, insufficient strength for clean removal from the circuit board and uncured flow properties which do not process cleanly and in some cases cause problems with removal as evident from cured masking material left behind on the circuit board. It was quite unexpectedly that a maskant was found which had sufficient strength, flow characteristics and solvent resistance which made it suitable for a mask on printed circuit boards and electronic parts, i.e. connectors, switches, etc.

The present invention provides a composition, referred to as a maskant, which cures both by exposure to ultraviolet radiation and can optionally be cured by heat with the addition of an organic peroxide. This maskant unexpectedly cures to films which exhibits superior solvent resistance, strength, elongation, tear strength compared to the maskant described in EP-A-0 384 616. This known maskant consists essentially of an methane acrylate prepolymer with 2 acrylate groups per molecule, an methane acrylate oligomer mixture with tripropylene glycol diacrylate, 2-hydroxy-methyl-1-phenylpropane-1-one as a photo initiator, and silica with a surface area greater than 150 m²/g.

The maskant of this invention also has improved flow characteristics which provides excellent processability. This maskant can be dispensed onto the desired area and it will remain on the appropriate area until cured by exposure to ultraviolet radiation, cure is quickly accomplished, it does not flow into undesired area before cure and is removable from pin holes into which it flows.

This invention relates to a method for making an electronic device using a masking material comprising dispensing an ultraviolet radiation curable, solventless, maskant comprising a polymer curable upon exposure to ultraviolet radiation, a photoinitiator and a reinforcing silica, on a substrate in at least one location to be masked, the maskant flowing to cover only the location to be masked and remaining in that position until irradiated with ultraviolet radiation, irradiating the maskant with ultraviolet radiation to cure it to a tack free, solvent resistant mask which remains in place during processing operations and then removing the mask from the masked location of the substrate, in one piece, without leaving deposits of cured material behind and without otherwise damaging the substrate, wherein the ultraviolet radiation curable, solventless maskant is a maskant consisting essentially of
(A) 100 parts by weight of a polyester urethane acrylate containing an average of about 2 acrylate groups per molecule, said polyester urethane acrylate being based on aromatic isocyanate and having from 0.02 to 0.08 unsaturation equivalents per 100 grams,
(B) 8 to 80 parts by weight of hydroxypropylmeth-acrylate,
(C) 0.8 to 10 parts by weight of 2- hydroxy-2-methyl-1-phenylpropan-1-one,
(D) 1.5 to 20 parts by weight of amorphous silica filler having a surface area of from 150 to 300 square meters per gram, and
(E) 0 to 3 parts by weight of 1,1-bis(t-butylperoxy)cyclohexane.

This invention further includes an ultraviolet curable maskant consisting essentially of (A) 100 parts by weight of a polyester urethane acrylate containing an average of about 2 acrylate groups, said polyester urethane acrylate being based on aromatic isocyanate and having from 0.02 to 0.08 unsaturation equivalent per 100 grams, (B) 8 to 80 parts by weight of hydroxypropylmethacrylate, (C) 0.8 to 10 parts by weight of 2- hydroxy-2-methyl-l-phenylpropan-1-one, (D) 1.5 to 20 parts by weight of amorphous silica filler having a surface area of from 150 to 300 square meters per gram and (E) 0 to 3 parts by weight of 1,1-bis(t-butylperoxy)cyclohexane.

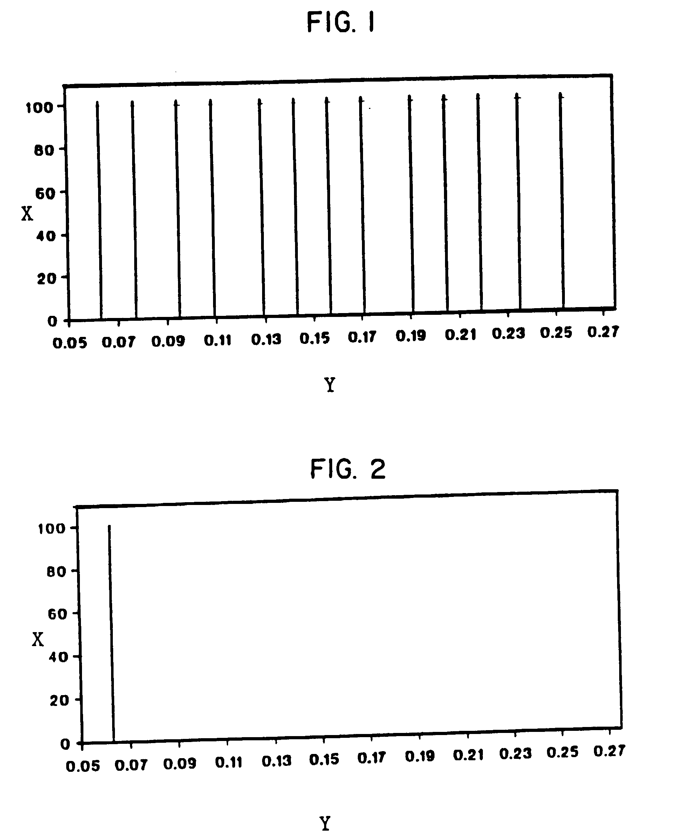

In the drawings, FIG 1 is a graph showing the results of a mask pull-out test where the mask was obtained by exposing Maskant A according to the present invention as described in Example 1 of this application to ultraviolet radiation to form a mask over a substrate having holes of different diameters.

FIG 2 is a graph showing the results of a mask pull-out test where the mask was obtained by exposing Comparative Maskant B which was prepared from an acrylated urethane oligomer composition which was based on an aliphatic isocyanate further described in Example 1. This mask was a prior art mask prepared from a composition as described in EP-A-0 384 616.

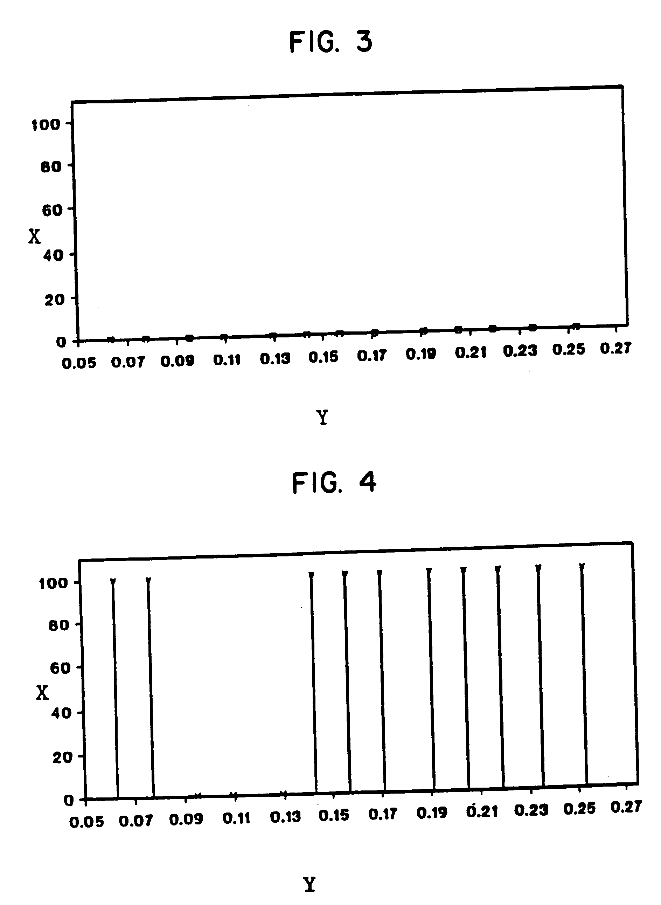

FIG 3 is a graph showing the results of a mask pull-out test where the mask was obtained by exposing Comparative Maskant B which was prepared from a composition similar to the composition described in Example 1 of U.S. Patent No. 4,780,486, issued October 25, 1988, to Chi-long Lee and Michael Andrew Lutz. This prior art mask was based on a composition containing vinyl containing polydimethylsiloxane, a mercapto functional polymethylsiloxane, a photoinitiator and silica filler, further described in Example 1.

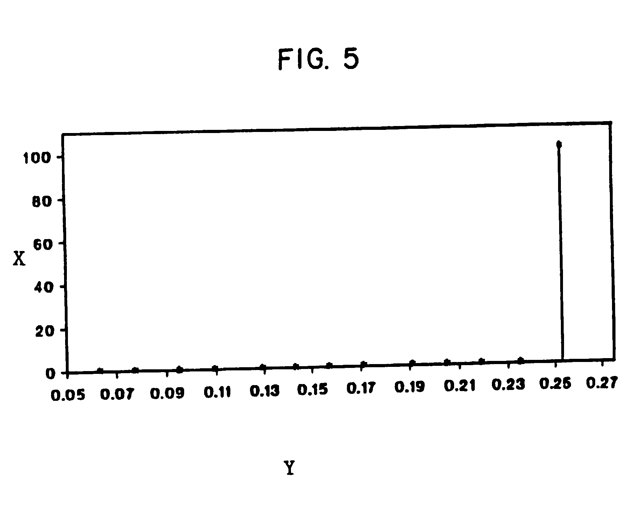

FIG 4 is a graph showing the results of a mask pull-out test where the mask was obtained by exposing Comparative Maskant C which was similar to the one used in FIG 3 but where the amounts of the ingredients were varied, further described in Example 1.

FIG 5 is a graph showing the results of a mask pull-out test where the mask was obtained by exposing Comparative Maskant D which was Loctite Litemask, Lot No. 9EN620 manufactured by Loctite, Newington, Connecticut, further described in Example 1.

The maskants of the present invention are curable by exposure to ultraviolet radiation. The present maskants can be cured by exposure to ultraviolet radiation, but can also be made to possess the ability to cure by heating, i.e., post curing or shadow curing.

The method of the present invention using the novel maskant for protecting certain areas by masking is fast, usable with many kinds of devices such as connectors, stand offs, sockets, trim pots, chip carriers and switches including dip switches and produces components with clean areas where the mask is located. The masked locations are protected from contamination during initial processing through the conformal coating processing steps such as found in the manufacture of printed wire boards designated PWB's or printed circuit boards designated PCB's. The method of this invention provides a temporary protective coating for PC (printed circuit) edge card connectors or printed circuit boards during assembly processes.

The electronic devices to be manufactured using a mask have at least a portion of the device which requires that it remain free from contamination, with the remaining portion of the device requiring processing which can be the source of the contamination. The portion to remain free from contamination is masked with a material so that during additional processing, contamination is prevented. The masking material, i.e. maskant, useful in the method of this invention is a unique material which is an ultraviolet radiation curable material. It is solventless, thixotropic and elastomeric. The maskant must be capable of being dispensed from a nozzle or tube at a sufficient rate to be useful for rapid production of the electronic devices. The portion of the electronic device can be rather small such as one or two millimeters in width and length. It should be understood that the particular geometry in not a limiting feature of the present invention and the use of width and length measurements are merely presented for illustrative purposes. The illustration is used to provide an understanding that the dispensing apparatus can have an orifice which is very small, such as a needle orifice with an inside diameter of 0,15 mm (0.006 inch) and the amount of maskant which is deposited at any one location on an electronic device can be a small amount. This illustration also provides an understanding that the maskant has flow properties which makes it useful for the method of this invention. The maskant must be able to flow through a orifice or nozzle which is small enough to deposit a quantity of the material in a one or two millimeter portion. The maskant must also not flow beyond the desired boundaries, i.e., the maskant must have sufficient thixotropic properties so that once the exerting force used to dispense the maskant is removed, the maskant will flow only to the preselected dimensions and no further before the maskant can be irradiated with ultraviolet radiation to cause it to cure. The maskant must have thixotropic properties so that it will not flow into holes to depths which could cause difficulties in removal of the mask. The removal of the mask from the electronic device can be aided by forming a tab of the maskant on the mask. This tab can be a blob of maskant protruding away from the device so as to allow grasping for the purpose of lifting the mask from the device. This tab can be formed by allowing the maskant to flow in one direction more than in other directions, such as a gravity flow at the edge of a device before the maskant is cured by irradiation with ultraviolet radiation. The tab can also be formed by extruding material beyond the device.

The kind of dispensing equipment is not particularly critical, as long as, it can dispense a preselected amount of maskant in the preselected location on the device (or preselected portion of the device). The dispensing equipment must have the capability of forcing the maskant out of the orifice without destroying its thixotropic characteristic. The dispensing process can also be done by hand using a pressurized dispenser. Materials which have thixotropic characteristics are best dispensed through equipment which does not produce high shear during any pumping or forcing operation, because high shear can cause destruction of the thixotropic characteristic. After the maskant is dispensed from the dispensing orifice, it should be allowed to flow only to the predetermined boundaries and when it reaches these boundaries, the maskant is irradiated with ultraviolet radiation which has a wavelength, is of an intensity and for a time period sufficient to cure the particular maskant. The specific source of ultraviolet radiation is not critical per se, as long as, it will cure the composition to a tack free, solvent resistant material which will remain in place during solvent cleaning operations, as well as, flow soldering, wave soldering operations and conformal coating. Another characteristic of the cured maskant, i.e. the mask, is that it has stable physical properties over a broad temperature range.

By the term "solvent resistant material", it is meant that the mask does not change shape, swell, soften or loose its seal with the substrate. The loss of the seal with the substrate will be considered a failure of the mask because this would allow contaminants to penetrate the area (location or portion) of the device which is to be protected, i.e. the main purpose of using a mask is protecting an area. The term "does not change shape" means that the shape of the mask remains substantially constant during the operations such as solvent cleaning and flow soldering operations. A slight change which does not alter the purpose of the mask is not to be excluded but is well within the scope of this invention. Likewise the mask may swell or soften slightly and still be within the scope of this invention. The intent is that the change in shape, swelling or softening will not interfere with the function of the masking operation of the electronic device during additional manufacturing processes. The mask made from the composition of this invention is to be resistant to solvents, such as isopropyl alcohol and fluorocarbon solvents such as Freon® TF, Genesolv DFX, Freon® TMS and Fluorinert.

After the manufacturing operations are completed and the mask is no longer needed to protect the predetermined location on the electronic device, the mask is removed. Removing the mask from the substrate is an important operation. The mask made from the composition of this invention is tough enough to be removed without leaving material on the substrate or in the holes of the device. This toughness is evident from the combination of tensile strength, elongation and tear strength possessed by the mask. The masks exhibit elongations of about 200% at break or more, such as about 300%, with tensile strengths of more than 6,9 MPa (1000 psi) at break, such as 27,6 MPa (4,000 psi). With Die B tear strengths of greater than 26,3 kN/m (150 ppi) above 35 kN/m (200 ppi) were recorded, the compositions of this invention provide excellent mask because they also possess the ability to be removable from devices with holes of varying sizes without leaving residue in the holes and they come off in one piece. Additionally, these maskants have excellent solvent resistance and the uncured properties allow for easy application to the device. Tabs can be formed from the maskant which makes the masks removal easier and more readily lends the removal operation to automation. The mask must not leave deposits on the substrate, this is often called slivering and it must not otherwise damage the substrate. For example, if the mask covers detailed elements of an electronic device, such as a switch of small size, the removal process must not damage the switch.

From the foregoing process requirements, the criticality of the maskant is shown. The maskant must be cured rapidly on demand by exposure to ultraviolet radiation so that it can be maintained in the desired configuration over the area of the device to be protected from contamination. The maskant must cure to a material with a tack free surface and must form a seal with the substrate so as not to allow contaminants to reach the areas to be protected. This means that the protected area will remain sealed against contaminants during further manufacturing steps in the production of electronic device. This seal must be sufficient to withstand such operations and still allow the mask to be removed from the electronic device without leaving material behind on the substrate and without damaging the device. These characteristics are often opposed to one another. In developing materials which have a sufficient seal, means increasing the adhesion, but increasing the adhesion means that the material will be more difficult to remove from the substrate resulting in deposits being left behind or damaged elements of the electronic device during the removal step. Further the solvent resistance and thermal resistance are to be achieved with a solventless composition with cures to an elastomer. The composition is also ultraviolet radiation curable, thixotropic and dispensable from a small orifice. The mask must also have sufficient thermally stability to withstand temperatures up to 650°C (1200°F) for periods of less than five seconds.

The present maskants can be used to mask complex devices in which there are regions or locations where it may come into contact with shapes from which it will need to be removed without damaging the component on the device or from a hole in the device. Because the ultraviolet irradiation of the maskant may not thoroughly cure some portions to be masked, heating may be used to make sure that the entire mask is cured so that it will be removed in one piece when the processing of the electronic device is completed. The maskants of the present invention can have the ability to cure via heating. An organic peroxide is added to the maskant when such heating is required. However, the use of organic peroxide is not desirable from a storage stand point because it lowers the shelf life by a substantial amount even in the presence of gelation inhibitors, such as p-methoxy-phenol and phenothiazine.

The amount of heat and the duration of the heating necessary to cure the present maskant is relatively low. The ability to cure the maskants with low amounts of heat is important because many of the electronics materials and construction can be affected by exposure to high temperatures or to heat for long durations. The maskants of the present invention are storable in one package over long periods of time, such as more than three months if organic peroxide is not present. The maskant, without the organic peroxide, can be packaged in a single container for storage and then used without there being any substantial change in the properties of curing or the physical and chemical properties of the cured product. Sometimes a viscosity increase may be observed but with simple shearing, such as by stirring, the viscosity will fall within the acceptable range. Maskants which contain organic peroxide are observed to cure within as little as seven days at 43°C. and therefore it is recommended that those situations where organic peroxide is desirably used, it should be added within a short time before applying the maskant.

The maskants of the present invention contain (A) a polyester urethane acrylate in which there is an average of about two acrylate groups per molecule, this polyester urethane acrylate oligomer is based on an aromatic isocyanate. The aromatic isocyanates include toluene diisocyanate. The polyester urethane acrylates of this invention have an unsaturation equivalent of from 0.02 to 0.08 unsaturation equivalents per 100 gram of the polyester urethane acrylate, preferably the unsaturation equivalent is from 0.03 to 0.06. The toughness of the mask was unexpectedly found to be substantially lower when higher unsaturation equivalent urethane acrylates were used or when the urethane acrylate was based on an aliphatic isocyanate.

The maskants of the present invention include, per 100 parts by weight of (A), 8 to 80 parts by weight of hydroxy-propylmethacrylate of (B), preferably from 40 to 65 parts by weight.

The compositions of the present invention contain (C) 2-hydroxy-2-methyl-1-phenylpropan-1-one as the photoinitiator to provide the ultraviolet radiation curable property. The photoinitiator is used in amounts of from 0.8 to 10 parts by weight, preferably from 1.5 to 5 parts by weight and which are suitable to provide cure of the composition when it is exposed to ultraviolet radiation. This amount of 2-hydroxy-2-methyl-1-phenylpropan-1-one cures the maskant completely. The inventors believe that the completeness of the cure may play a role in the adhesion of the cured composition to substrates, to the other properties of the cured material and to the ability of the mask to be removed in one piece without leaving residue either on the substrate or in the substrate holes.

The maskants of this invention require that the thixotropic nature of the maskant be such that it neither flow too rapidly so that it covers areas which should not be masked or not flow enough so that it does not cover the areas which are to be masked. To accomplish this thixotropic characteristic, (D) an amorphous silica filler having a surface area of from 150 to 300 square meters per gram is used in an amount of from 1.5 to 20 parts by weight per 100 parts by weight of (A), preferably from 8 to 15 parts by weight. A particularly useful silica is fumed silica. The required thixotropy for the maskant is such that it can be dispensed from an orifice to the use area and deposited with low force and that it will flow, but only, to the extent that it will not flow into a hole with a diameter in the range of from 1,3 mm (0.05 inch) to 7,6 mm (0.30 inch) to a depth of more than about 6,4 mm (0.25 inch) without completely pulling out, so that the mask is removable as one piece including any mask material in the pin holes. The maskant preferably has a viscosity of from 100,000 to 600,000 mPa·s measured with a Brookfield Model HATD viscometer using a number 3 spindle, at 0.5 revolutions per minute. The maskants of the present invention must be of sufficiently low viscosity to fill the voids between contact tails and their individual cavities without penetrating too deeply into the connector insulator holes. Thus, the maskant must be thixotropic with the capability of being dispensed from a small nozzle and then quickly reverting to a highly viscous material which will not flow to any substantial degree before it cures.

The present maskant of this invention may contain (E) from 0 to 3 parts by weight of 1,1-bis(t-butylperoxy) cyclohexane which is an amount sufficient to provide cure when the maskant is exposed to heat after the maskant is cured by exposure to ultraviolet radiation. Such maskants could be cured by heating alone. This organic peroxide is one which is more stable in the uncured composition of the present invention, which cures upon heating and which does not produce acidic by-products that can cause corrosion to electronic materials. Maskants of this invention which contain this organic peroxide are not shelf stable at ambient temperatures when packaged in a single container over long periods of time and should be used within about one week once the organic peroxide is added.

The connector pin hole adhesion as used in this application relates to adhesion whether mechanical or chemical is satisfactory when the cured film allows for processing with degreasing solvents without it delaminating and the connector pin holes remained sealed. However, the mask of this invention was unexpectedly found to be removal in one piece without leaving residue in the connector pin holes over the entire range of pin holes having sizes ordinarily used in printed circuit boards. These pin holes are ordinarily of sizes from about 1,3 mm (0.05 inch) to at least 7.6 mm (0.30 inch) in diameter.

The maskants of the present invention may contain other ingredients such as fungicides or colorants which includes fluorescent dyes and visible light organic dyes, as long as these materials do not add to the corrosive nature of the maskant or deleteriously effect the electrical and other physical properties of the uncured maskant or the cured product, the mask. Inhibitors may be present in the maskant to keep it stable during storage. These storage inhibitors may be found in the polyester urethane acrylate or the hydroxypropylmeth-acrylate. Their amounts in these ingredients are usually sufficient to allow storage stabilities such that the maskant of this invention will remain usable for more than one year. Examples of such inhibitors are 4-methoxyphenol and phenothiazine.

The maskant of this invention is one which will not corrode the electronic components it contacts either in the uncured or cured state. The maskant is sufficiently neutral and must not contain ingredients which may change this neutrality. A change in neutrality results in a maskant which may cause corrosion to materials used in electronic components. For example, the maskant of the present invention should not contain amines, such as the tertiary organic amines which are often used as co-initiators with photosensitizers, because these amines cause corrosion to metal substrates found in the electronic components. Also acidic materials should not be used in the maskants of the present invention because these materials also cause corrosion.

The maskants of the present invention are maskants particularly useful in forming masks to be used during processing of printed circuit boards and other electronic devices. Such masks typically have thicknesses of 0,6 to 2.54 mm (25 to 100 mils).

The maskants of this invention can be cured by exposure to ultraviolet radiation to make the mask. If portions of the mask remain uncured after exposure to ultraviolet radiation, organic peroxide can be added to the maskant so that it will cure by heating. Thus, the maskant can be made to cure in the dark regions (regions not receiving ultraviolet radiation exposure). The masks have solvent resistance to such solvents as xylene, acetone, isopropanol, methyl ethyl ketone, Freons and urethane thinners. As stated, the maskants are sufficiently thixotropic to be applied and then stay in the desired area until they are cured. The maskants are non-corrosive before, during and after cure, where cure includes both the ultraviolet cure and the post heat cure. The maskants have the ability to withstand thermal shock from -65°C. to 120°C. The maskants of this invention when cured sufficiently exhibit a low weight loss upon subjecting to hot or cold degreasing solvents. The maskants exhibit acceptable electrical properties for use as insulative coatings and encapsulants for electronic components, such as volume resistivity and dielectric withstanding voltage. The maskants of the present invention exhibits sufficient fungus resistance without the addition of additional fungicides, but in certain applications it may be advantageous to add to this fungus resistance. If additional fungicide is needed, careful evaluation of the fungicide should be conducted to determine its effect on other properties, such as corrosion. The maskants also exhibit humidity resistance and resistance to soldering heat.

The following examples are presented for illustrative purposes and should not be construed as limiting the invention which is properly delineated in the claims. In the following examples, "part" or "parts" represents "part by weight" or "parts by weight."

### Example 1

Maskant A of this invention was prepared by heating to 40°C. in a Neulinger mixer (manufactured by Neulinger Kreuziger of Austria), 100 parts of a polyester urethane acrylate prepared from aromatic isocyanate, having an unsaturation equivalent in the range of from 0.036-0.048 equivalents/100 grams, an isocyanate content of less than 0.3% by weight and viscosities of 80-160 Pa·s (800-1600 poise) at 49°C., 20-35 Pa·s (200-350 poise) at 71°C. and 8.5-16.5 Pa·s (85-165 poise) at 82°C. This polyester urethane acrylate was Uvithane(R) 782 Oligomer, from Morton Thiokol, Inc., Morton Chemical Division, Chicago, Illinois. Uvithane® 782 oligomer contains about 50 ppm of phenothiazine and about 100 ppm 4-methoxyphenol(MEHQ). Then 49 parts of hydroxypropylmethacrylate and about 0.02 part of 4-methoxyphenol was stirred into the polyester urethane acrylate. After the hydroxyproplymethacrylate was mixed in 3 parts of 2-hydroxy-2-methyl-1-phenylpropan-1-one and 10 parts of fumed silica filler having a specific surface area of 200 square meters per gram were blended into the mixture. Maskant A was stored in a container which was opaque to ultraviolet radiation. Maskant A remained essentially unchanged for more than three months at 46°C. which was an accelerated shelf life study.

Comparative Maskant A was prepared as follows. In a Neulinger mixer containing an agitator, a dissolver blade and a wiper blade, 22.75 parts of urethane acrylate prepolymer prepared from aliphatic isocyanate (Ebecryl® 4883 sold by Radcure Specialties of Virginia and was 85% by weight of urethane acrylate oligomer and 15% by weight of tripropylene glycol diacrylate where the oligomer has a molecular weight of about 1,600 and a viscosity at 60°C. of 2,8 to 4.2 Pa·s), 22.75 parts of urethane acrylate oligomer prepared from aliphatic isocyanate (Ebecryl® 230 sold by Radcure Specialties of Virginia and was a 100% solids urethane acrylated oligomer with a viscosity of 30 to 40 Pa·s at 25°C. and a number average molecular weight of about 5,000 and an unsaturation equivalent of about 0.04 equivalents per 100 gram based on a functionality of two per molecule) and 3 parts of 2-hydroxy-2-methyl-1-phenylpropan-1-one (Darocur 1173) were mixed at 3 rpm for five minutes to provide a homogeneous mixture. At this point 3 parts of reinforcing silica (Cab-O-Sil® MS-7) was admixed with the homogeneous mixture at 3 rpm for five minutes to wet out the silica. An additional 3 parts of the silica was added and mixing was continued with the agitator at 3 rpm for another five minutes. The dissolver blade was turned on at 1500 to 1600 rpm for five minutes, the mixer was turned off and the filler was scraped down using the wiper blade, mixing was then continued with the agitator at 3 rpm and the dissolver blade at 1500-1600 rpm for 10 minutes, adding 22.75 parts of Ebecryl 4883 and 22.75 parts of Ebecryl® 230 to the mixer and the mixing was resumed with the agitator at 3 rpm and the dissolver blade at 1500-1600 rpm. The resulting composition was stored in a container which was opaque to ultraviolet radiation.

A Comparative Maskant B was prepared by mixing 107.1 parts of a mixture of 34.1 parts of xylene, 25.6 parts of a benzene soluble silicone resin containing dimethylvinylsiloxy units, trimethylsiloxy units and SiO₂ units where the ratio of the sum of the mols of dimethylvinylsiloxy units and trimethylsiloxy units to SiO₂ units was 0.65:1 and there was 1.9 weight percent vinyl radical in the resin and 47.4 parts of dimethylvinylsiloxy endblocked polydimethylsiloxane having a viscosity of about 2 Pa·s. The mixture was stripped of xylene by heating to 100°C. at a pressure of about 670 Pa resulting in a polymer-resin blend. A mercapto functional polyorganosiloxane of the average formula 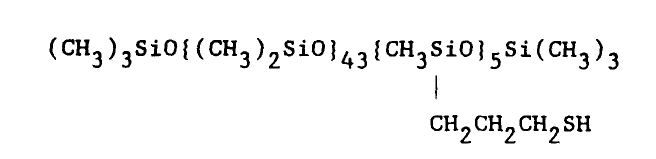 in an amount of 11.1 part and 1.1 part of di-isopropylaminoethanol was mixed with the polymer-resin blend. Then, 1 part of 2-hydroxy-2-methyl-1-phenylpropan-1-one was added and mixed well and, thereafter, 2 parts of amorphous silica having the surface treated with trimethylsiloxy units was added and when the silica was well dispersed another 1 part of 2-hydroxy-2-methyl-1-phenylpropan-1-one was added and mixed well. The resulting Comparative Maskant B was stored in a container opaque to ultraviolet radiation.

A Comparative Maskant C was prepared as described above for Comparative Maskant B except that the amount of mercapto functional polyorganosiloxane used was 19 parts, the amount of di-isopropylaminoethanol was 0.9 part, the amount of silica used was 6 parts and the total amount of 2-hydroxy-2-methyl-1-phenylpropan-1-one was 3 parts.

Comparative Maskant D was a commercial ultraviolet radiation curable material which was obtained from Loctite and was labeled Loctite Litemask, Lot No. 9EN620.

Mask Pull-out Test were performed using each of the maskants described above. Each of the above maskants were syringed into holes 6,35 mm (0.25 inch) on an FR-4 board substrate which contained holes varying in diameter, namely 1.6, 2.0, 2.4, 2.8, 3.2, 3.6, 4.0, 4.3, 4.8, 5.2, 5.6, 6.0, and 6.5 mm (0.063, 0.077, 0.094, 0.109, 0.128, 0.142, 0.156, 0.170, 0.190, 0.205, 0.219, 0.235 and 0.254 inch) as shown in the graphs of Figures 1 through 5. The board was coated on one side to make sure all the holes were connected by a film. The maskants were exposed to ultraviolet radiation from a Colight laboratory curing unit, manufactured by Colight, Minneapolis, Minnesota to cure them. Each side of the board was given dosage of 4 J/cm² and then the mask were removed by pulling the mask from the substrate by using a flat separating means to aid in pulling the mask from the holes in a perpendicular manner to the board and the percentage of the holes which contained mask material were observed. It was noted that either the mask remained in all the holes of one size or the mask was completely removable in one piece. This phenomena of being either completely removable or completely remaining in the holes was entirely unexpected. The differences were observed based on different size holes. In the graphs of FIG 1 to FIG 5, the "x" axis is the percentage of holes in which no mask material remained and the "y" axis is the hole diameter. The hole diameters ranged from about 1.6 mm (0.063 inch) to about 6.5 mm (0.254 inch).

FIG 1 is the graph showing the result of using the maskant of the present invention described above as Maskant A. The mask prepared from Maskant A was 100% removable from each hole throughout the range tested. This result was unexpected based on the results obtained from other prior art maskants.

FIG 2 is the graph showing the results of using a prior art maskant described above as Comparative Maskant A which was a composition within the scope of the masking material described by Buentello et al in the copending application cited herein. Mask made from the Buentello et al composition resulted in complete removal of the mask in one piece only at the smallest diameter hole, the 1.6 mm (0.063 inch) hole and the holes of the other diameters retained the mask material, which was a very poor result and as such would interfere with the manufacture of a printed circuit board which contained pin holes of the diameters above about 1.6 mm (0.063 inch) in diameter.

FIG 3 is the graph showing the results of using a prior art maskant described above as Comparative Maskant B which was a composition within the scope of the material described in the Lee et al patent cited herein. The maskant to be retained in each of the pin holes of the Mask Pull-out Test regardless of the diameter.

FIG 4 is the graph showing the results of using a prior art maskant described above as Comparative Maskant C which was a composition within the scope of the material described in the Lee et al patent cited herein. Comparative Maskant C was similar to Comparative Maskant B except the amounts of the ingredients were varied. Mask made from the Lee et al composition resulted mask material being retained in holes which ranged in diameters of from about 2.4 to 3.3 mm (0.094 to 0.128 inch). Such a result would require the careful sizing of pin holes.

FIG 5 is the graph showing the results of using a commercial maskant manufactured by Loctite as described above as Comparative Maskant D. This maskant was only completely removable at the hole diameter of 6.5 mm (0.254) and remained in the holes of the other diameters tested.

From the Mask Pull-out Test, only the maskant of the present invention was completely removable over the entire range of diameters of the holes tested.

### Example 2

Maskant A, Maskant B, Comparative Maskant A, Comparative Maskant E and Comparative Maskant F were cured by using a draw down bar to deposit 1.3 mm (50 mil) (wet) on an aluminum Q panel and then exposing the maskant to 3 J/cm² of ultraviolet radiation from an LCU 750, manufactured by UVEXS, Inc. of Sunnyvale, California. The tensile strength at break, the elongation at break, the tear strength, Die B and the 50% modulus were measured. The results were as shown by Table I.

Maskant B was prepared as described for Maskant A except there was added as the last ingredient 2.3 parts of USP-400P which was 1.57 parts of l,l-bis(t-butylperoxy) cyclohexane in 0.39 part of butyl benzyl phthalate and was sold by Witco Chemical, Richmond, California. Maskant B was stored in a container opaque to ultraviolet radiation. In an accelerated shelf life study, Maskant B was stored at 46°C. and it gelled in 7 days which was unexpected because Maskant B had been post cured by heating for 10 minutes at 43°C. after being exposed to ultraviolet radiation. Whereas Maskant A cured to a depth of 6.35 mm (0.25 inch) by exposure to 4 J/cm², Maskant B cured to a depth of at least 12.7 mm (0.5 inch) with a post cure of 10 minutes at 43°C.

Comparative Maskant E was prepared in the same manner as described for the preparation of Maskant A in Example 1 the following ingredients:
100 parts of an acrylated urethane oligomer mixture having 90 parts of acrylated urethane oligomer and 10 parts of ethoxyethoxyethyl acrylate, the mixture having a viscosity of 9,800 cps at 65°C., a specific gravity of 1.05, an unsaturation equivalent of 0.147 equivalents per 100 grams and an isocyanate content of less than 0.2 percent, the acrylated urethane oligomer was based on an aliphatic isocyanate and was sold by Radcure Specialties, Inc of Atlanta, Georgia as Ebecryl® 8800 UV/EB Curable Resin,
49 parts of hydroxypropylmethacrylate and about 0.02 part of 4-methoxyphenol, 3 parts of 2-hydroxy-2-methyl-1-phenylpropan-1-one, and
10 parts of fumed silica filler having a specific surface area of 200 square meters per gram.

Comparative Maskant F was prepared as described for Maskant A of Example 1 except that the amounts of the ingredients were 48 parts of the hydroxypropylmethacrylate and 2.9 parts of the 2-hydroxy-2-methyl-1-phenylpropan-1-one. No silica was used in this comparative maskant.

**TABLE I**

| MASKANT | VISCOSITY mPa·s | TENSILE (PSI) MPa | ELONGATION % | TEAR STRENGTH (PPI) kN/m | 100% MODULUS (PSI) kPa |
|---|---|---|---|---|---|
| A(LOT 1*) | 488,800 | (4,378) 30.2 | 339 | (216) 37.8 | (1,482) 10218 |
| A(LOT 2*) | 453,600 | (3,645) 25.1 | 288 | (232) 40.6 | (1,419) 9784 |
| B(LOT 1*) | 348,00 | (3,615) 24.9 | 290 | (204) 35.7 | (1,395) 9618 |
| B(LOT 2*) | 365,600 | (3,895) 26.9 | 320 | (209) 36.6 | (1,353) 9329 |
| COMPARATIVE MASKANT | | | | | |
| A | 558,000 | (1,185) 8.2 | 98 | (57) 10 | (684) 4716 |
| E | --- | (5,171) 35.7 | 8 | (1,015) 177.8 | --- |
| F | --- | (2,929) 20.2 | 299 | (158) 27.7 | (1,001) 6902 |

| | | | | | |
|---|---|---|---|---|---|
| *The lot numbers refer to different lots of Uvithane 782. | | | | | |

The results of Table I show that the maskant of the present invention have a property profile which was tougher than the comparative maskants. Comparative Maskant A was deficient in all properties whereas Comparative Maskant E exhibited excellent tensile strength and tear strength but had very low elongation which was undesirable. The property profile of the maskant without (Maskant A) and with peroxide (Maskant B) were within the acceptable range.

### Example 3

A screening experiment was performed by blending various acrylate urethane oligomers with 3 weight percent 2-hydroxy-2-methyl-1-phenylpropan-1-one, test films were deposited and then the test films were exposed to ultraviolet radiation on the LCU described in Example 2 at 4 J/cm² and then testing the tensile strength at break, the elongation at break and the 50% modulus which were as shown in Table II. Several commercially available acrylated urethanes based on aromatic isocyanates and aliphatic isocyanates were evaluated as described in Table II.

**TABLE II**

| ACRYLATED URETHANE | UNSATURATION EQUIVALENT EQVIL./100g | TENSILE STRENGTH (PSI) kPa | ELONGATION % | 50% MODULUS (PSI) kPa |
|---|---|---|---|---|
| AROMATIC | | | | |
| UVITHANE® 782 | 0.036-0.048 | (757) 5219 | 202 | (215) 1482 |
| UVITHANE® 783 | 0.17-0.205 | (5,238) 36115 | 30 | (4,174) 32502 |
| EBECRYL® 4827 | 0.13** | (491) 3385 | 44 | (518) 3571 |
| EBECRYL® 6600 | 0.125** | (707) 4875 | 64 | (320) 2206 |
| EBECRYL® 6700 | 0.153** | (1,737) 11976 | 41 | (1,024) 7060 |

| ALIPHATIC | | | | |
|---|---|---|---|---|
| EBECRYL® 8800 | 0.147** | (3,273) 22567 | 32 | (2,237) 15424 |
| EBECRYL® 8400 | 0.04** | (173) 1193 | 86 | (108) 745 |
| EBECRYL® 230 | 0.04** | (183) 1262 | 77 | (124) 855 |
| UVITHANE® 892 | 0.05-0.06 | (470) 3241 | 110 | (213) 1469 |
| UVITHANE® 893 | 0.15-0.175 | (3,403) 23463 | 51 | (3,235) 22305 |

| | | | | |
|---|---|---|---|---|
| **UNSATURATION EQUIVALENT CALCULATED BASED UPON REPORTED FUNCTIONALITY AND MOLECULAR WEIGHT | | | | |

## Claims

1. A method for making an electronic device using a masking material comprising dispensing an ultraviolet radiation curable, solventless, maskant comprising a polymer curable upon exposure to ultraviolet radiation, a photoinitiator and a reinforcing silica, on a substrate in at least one location to be masked, the maskant flowing to cover only the location to be masked and remaining in that position until irradiated with ultraviolet radiation, irradiating the maskant with ultraviolet radiation to cure it to a tack free, solvent resistant mask which remains in place during processing operations and then removing the mask from the masked location of the substrate, in one piece, without leaving deposits of cured material behind and without otherwise damaging the substrate, wherein the ultraviolet radiation curable, solventless maskant is a maskant consisting essentially of
(A) 100 parts by weight of a polyester urethane acrylate containing an average of about 2 acrylate groups per molecule, said polyester urethane acrylate being based on aromatic isocyanate and having from 0.02 to 0.08 unsaturation equivalents per 100 grams,
(B) 8 to 80 parts by weight of hydroxypropylmeth-acrylate,
(C) 0.8 to 10 parts by weight of 2- hydroxy-2-methyl-1-phenylpropan-1-one,
(D) 1.5 to 20 parts by weight of amorphous silica filler having a surface area of from 150 to 300 square meters per gram, and
(E) 0 to 3 parts by weight of 1,1-bis(t-butylperoxy)cyclo-hexane.

2. An ultraviolet radiation curable maskant consisting essentially of
(A) 100 parts by weight of a polyester urethane acrylate containing an average of about 2 acrylate groups per molecule, said polyester urethane acrylate being based on aromatic isocyanate and having from 0.02 to 0.08 unsaturation equivalents per 100 grams,
(B) 8 to 80 parts by weight of hydroxypropylmeth-acrylate,
(C) 0.8 to 10 parts by weight of 2- hydroxy-2-methyl-1-phenylpropan-1-one,
(D) 1.5 to 20 parts by weight of amorphous silica filler having a surface area of from 150 to 300 square meters per gram, and
(E) 0 to 3 parts by weight of 1,1-bis(t-butylperoxy)cyclo-hexane.

## Patentansprüche

1. Verfahren zur Herstellung einer elektronischen Vorrichtung unter Verwendung eines Maskierungsmaterials umfassend, daß man ein durch Ultraviolettstrahlung härtbares, lösungsmittelfreies Maskierungsmittel, das ein Polymer, das durch Belichtung mit Ultraviolettstrahlung härtbar ist, einen Photoinitiator und ein verstärkendes Siliciumdioxid enthält, auf ein Substrat an mindestens einer zu maskierenden Stelle aufträgt, wobei das Maskierungsmittel so fließt, daß es nur die zu maskierende Stelle bedeckt und in dieser Position bleibt, bis es mit Ultraviolettstrahlung bestrahlt wird, das Maskierungsmittel mit Ultraviolettstrahlung bestrahlt, um es zu einer klebefreien, lösungsmittelbeständigen Maske zu härten, die während der Verarbeitungsstufen an Ort und Stelle bleibt, und dann die Maske von der maskierten Stelle auf dem Substrat in einem Stück entfernt, ohne daß Rückstände des gehärteten Materials zurückbleiben und ohne das Substrat in anderer Weise zu schädigen, wobei das durch Ultraviolettstrahlung härtbare, lösungsmittelfreie Maskierungsmittel ein Maskierungsmittel ist, das im wesentlichen aus
(A) 100 Teilen eines Polyesterurethanacrylats mit durchschnittlich etwa zwei Acrylatgruppen pro Molekül, wobei das Polyesterurethanacrylat auf einem aromatischen Isocyanat basiert und 0,02 bis 0,08 Äquivalente ungesättigte Bindungen pro 100 g aufweist,
(B) 8 bis 80 Gewichtsteilen Hydroxypropylmethacrylat,
(C) 0,8 bis 10 Gewichtsteilen 2-Hydroxy-2-methyl-1-phenylpropan1-on,
(D) 1,5 bis 20 Gewichtsteilen eines amorphen Siliciumdioxidfüllstoffs mit einer Oberfläche von 150 bis 300 m²/g und
(E) 0 bis 3 Gewichtsteilen l,l-Bis(t-butylperoxy)cyclohexan besteht.

2. Durch Ultraviolettstrahlung härtbares Maskierungsmittel bestehend im wesentlichen aus
(A) 100 Gewichtsteilen eines Polyesterurethanacrylats mit durchschnittlich etwa zwei Acrylatgruppen pro Molekül, wobei das Polyesterurethanacrylat auf einem aromatischen Isocyanat basiert und 0,02 bis 0,08 Äquivalente an ungesättigten Bindungen pro 100 g aufweist,
(B) 8 bis 80 Gewichtsteilen Hydroxypropylmethacrylat,
(C) 0,8 bis 10 Gewichtsteilen 2-Hydroxy-2-methyl-1-phenylpropan-1-on,
(D) 1,5 bis 20 Gewichtsteilen amorphem Siliciumdioxidfüllstoff mit einer Oberfläche von 150 bis 300 m²/g und
(E) 0 bis 3 Gewichtsteilen 1,1-Bis(t-butylperoxy)cyclohexan.

## Revendications

1. Un procédé de fabrication d'un dispositif électronique utilisant une matière de masquage, consistant à appliquer une matière de masquage sans solvant, durcissable par irradiation ultraviolette, comprenant un polymère durcissable par exposition à un rayonnement ultraviolet, un photo-initiateur et une silice de renforcement, sur un substrat en au moins un emplacement à masquer, la matière de masquage s'écoulant pour ne recouvrir que l'emplacement à masquer et restant dans cette position jusqu'à ce qu'elle soit irradiée par un rayonnement ultraviolet, à irradier la matière de masquage par un rayonnement ultraviolet pour la durcir en formant un masque non poisseux, résistant aux solvants, qui reste en place pendant les opérations de traitement, puis retirer le masque en une seule pièce de l'emplacement masqué du substrat, sans laisser de dépôts de matière durcie et sans endommager le substrat de quelque autre manière, dans lequel la matière de masquage sans solvant, durcissable par irradiation ultraviolette, est une matière de masquage constituée essentiellement de
(A) 100 parties en poids d'un polyester uréthanne acrylate contenant en moyenne environ 2 groupes acrylate par molécule, ledit polyester uréthanne acrylate étant à base d'isocyanate aromatique et ayant 0,02 à 0,08 équivalent d'insaturation pour 100 grammes,
(B) 8 à 80 parties en poids de méthacrylate d'hydroxypropyle,
(C) 0,8 à 10 parties en poids de 2-hydroxy-2-méthyl-1-phénylpropane-1-one,
(D) 1,5 à 20 parties en poids d'une charge de silice amorphe ayant une surface spécifique de 150 à 300 mètres carrés par gramme, et
(E) 0 à 3 parties en poids de 1,1-bis(*t*-butylperoxy)cyclohexane.

2. Une matière de masquage durcissable par irradiation ultraviolette, constituée essentiellement de
(A) 100 parties en poids d'un polyester uréthanne acrylate contenant en moyenne environ 2 groupes acrylate par molécule, ledit polyester uréthanne acrylate étant à base d'isocyanate aromatique et ayant 0,02 à 0,08 équivalent d'insaturation pour 100 grammes,
(B) 8 à 80 parties en poids de méthacrylate d'hydroxypropyle,
(C) 0,8 à 10 parties en poids de 2-hydroxy-2-méthyl-1-phénylpropane-1-one,
(D) 1,5 à 20 parties en poids d'une charge de silice amorphe ayant une surface spécifique de 150 à 300 mètres carrés par gramme, et
(E) 0 à 3 parties en poids de 1,1-bis(*t*-butylperoxy)cyclohexane.
